# EUROPEAN PATENT APPLICATION

(11) **EP 3 457 562 A1**
(43) Date of publication of application: **20.03.2019**
(21) Application number: 16901637.5
(22) Date of filing: 11.05.2016
(51) Int. Cl.: H02S 30/20, B64G 1/44

(54) **PHOTOVOLTAIC GENERATION DEVICE, SOLAR BATTERY PADDLE, AND SPACE STRUCTURE**

(71) Applicant: Mitsubishi Electric Corporation, Chiyoda-ku Tokyo 100-8310 (JP)
(72) Inventor: TOMODA, Naoko, Tokyo 100-8310 (JP); TAKEYA, Hajime, Tokyo 100-8310 (JP); OHKUBO, Mitsuru, Tokyo 100-8310 (JP); KAWAKATSU, Shinobu, Tokyo 100-8310 (JP); SEKI, Kazuyoshi, Tokyo 100-8310 (JP)
(74) Representative: Sajda, Wolf E.
(86) International application number: PCT/JP2016/063975
(87) International publication number: WO 2017/195289

(57) **Abstract**

A solar power generator (30A) overlies a solar power generator (30B) when stowed. A plurality of solar cells (32) of the solar power generator (30A) includes first solar cells (32X) each having a corner (41) at one end of one side, and second solar cells (32Y) disposed adjacent to the first solar cells (32X). Each of the second solar cells (32Y) has a chamfered part (42) at an end, corresponding to the one end, of a side facing the one side. When viewed along thickness direction D3 of a support (31), a cushioning part (34) of the solar power generator (30A) is disposed between the corner (41) of the first solar cell (32X) and the chamfered part (42) of the second solar cell (32Y) and projects more outwardly along the thickness direction D3 of the support (31) than the plurality of solar cells (32).

## Description

### Technical Field

The present invention relates to a solar power generator, a solar array wing, and a space structure.

### Background Art

In association with increasing missions required of satellites and prevalence of spacecraft with electric propulsion, electric power needed for the satellites is on the rise in recent years. To meet this demand, various methods have been used to increase output power of solar array wings.

Specifically, there is a method of increasing conversion efficiency of solar cells mounted in a solar array panel and a method of reducing thickness of a substrate of the solar array panel. However, it is difficult to sufficiently increase the output power only with these methods.

Other methods include increasing panel size and increasing the number of panels. A solar array wing using the solar array panels, each of which is called a rigid type, has severe upper limits of the panel size and the number of panels because of a fairing size limit of a rocket.

As a countermeasure, adoption of a solar array blanket is under consideration. A solar array wing using the solar array blankets, each of which is called a flexible type, has less severe upper limit of the number of blankets compared with the case where the rigid type is used.

To maximize the number of blankets, a distance between the blankets has to be minimized without damage to solar cells.

There are conventional techniques for preventing damage caused by contact between solar cells on a panel. Patent Literature 1 discloses a technique of providing separators around a solar cell at positions corresponding to four corners of the solar cell. Patent Literature 2 discloses a technique of providing a cushioning member at chamfered corners of solar cells on a solar cell-mounting surface of a panel.

### List of Citations

### Patent Literatures

Patent Literature 1: JP S62-196875 A
Patent Literature 2: JP 2015-189469 A

### Summary of the Invention

### Technical Problem

In the technique disclosed by Patent Literature 1, the solar cell has a square shape or a square shape with its four corners cut off. With the square shape, a space between the cells must be increased to secure a space to place the separators, so that upper limits of cell size and the number of cells become severe. With the square shape with its four corners cut off, a space between the cells can be reduced, but a light receiving area of each of the cells decreases due to the four corners that have been cut off. That is, in both the cases, the provided separators impede increase of the output power.

In the technique disclosed by Patent Literature 2, the cushioning member is provided to partially cover the solar cells, so that the light receiving areas of the cells decrease by the area covered with the cushioning member. That is, the provided cushioning member impedes increase of the output power.

An object of the present invention is to prevent damage caused by contact between solar cells that are disposed on a front surface of a support without impeding increase of output power.

### Solution to the Problem

According to one aspect of the present invention, a solar power generator overlies another solar power generator when stowed.

The solar power generator includes:
a support;
a plurality of solar cells disposed on a front surface of the support and adjoined along a length direction of the support, the plurality of solar cells including:
   a first solar cell including a corner at one end of one side; and
   a second solar cell that is disposed adjacent to the first solar cell and includes a chamfered part at an end, corresponding to the one end, of a side facing the one side; and
a cushioning part that is disposed between the corner of the first solar cell and the chamfered part of the second solar cell when viewed along a thickness direction of the support and projects more outwardly along the thickness direction of the support than the plurality of solar cells.

### Advantageous Effects of the Invention

In the present invention, when viewed along the thickness direction of the support, the cushioning part projecting outward along the thickness direction of the support is disposed between the corner of the first solar cell and the chamfered part of the second solar cell that is adjacent to the first solar cell. As such, damage caused by contact between the solar cells that are disposed on the surfaces of supports can be prevented while increase of output power is not impeded.

### Brief Description of Drawings

- FIG. 1: is a sectional view of a fairing of a rocket that accommodates a space structure according to a first embodiment.
- FIG. 2: is a top plan view of a solar array wing according to the first embodiment.
- FIG. 3: is a perspective view of the solar array wing according to the first embodiment.
- FIG. 4: is a sectional view of a part of a solar power generator according to the first embodiment.
- FIG. 5: is a perspective view of the solar power generators, and partly enlarged view, according to the first embodiment.
- FIG. 6: illustrates an area where a cushioning part of the solar power generator is disposed according to the first embodiment.
- FIG. 7: is a sectional view of a part of a solar power generator in a variation of the first embodiment.
- FIG. 8: is a perspective view of solar power generators, and partly enlarged view, according to a second embodiment.
- FIG. 9: is a perspective view of solar power generators, and partly enlarged view, according to a third embodiment.
- FIG. 10: is a perspective view of solar power generators, and partly enlarged view, according to a fourth embodiment.
- FIG. 11: is a perspective view of solar power generators according to a fifth embodiment.
- FIG. 12: illustrates how the solar power generators overlie each other when stowed according to the fifth embodiment.
- FIG. 13: is a perspective view of solar power generators, and partly enlarged view, according to a sixth embodiment.
- FIG. 14: is a perspective view of solar power generators, and partly enlarged view, according to a seventh embodiment.

### Description of Embodiments

Embodiments of the present invention will now be described with reference to the drawings. Note that parts that are identical or equivalent to each other in the drawings are denoted by the same reference numerals. Descriptions of the parts that are identical or equivalent to each other will be omitted or simplified as appropriate in the description of the embodiments.

Moreover, in the description of the embodiments, the arrangement or orientation such as "upper", "lower", "left", "right", "front", "rear", "the front", or "the back" is denoted as such for the purpose of illustration and does not limit the arrangement or orientation of a device, an instrument, a part, and the like. The material, shape, size, and the like of the configuration of a device, an instrument, a part, and the like can be modified as appropriate within the scope of the present invention.

### First Embodiment

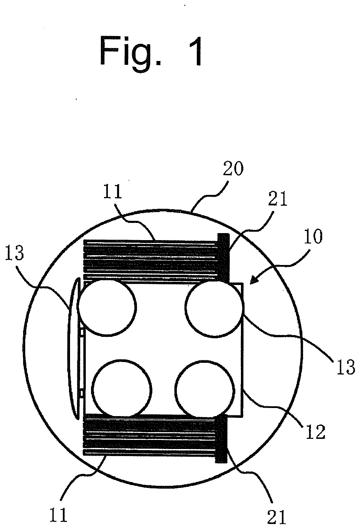

The present embodiment will be described with reference to FIGS. 1 to 6.

### Description of Configuration

The configuration of a space structure 10 according to the present embodiment will be described with reference to FIGS. 1, 2, 3, and 4.

The space structure 10 is a satellite in the present embodiment but may be a space structure of another kind such as a space station.

As illustrated in FIG. 1, the space structure 10 includes solar array wings 11, a structure body 12, and antennas 13.

The abbreviation for the solar array wing 11 is SAW. In the present embodiment, the solar array wings 11 are respectively connected to both sides of the structure body 12.

In the present embodiment, the structure body 12 is a satellite structure.

The antennas 13 are mounted on an upper surface and a front surface of the structure body 12 in the present embodiment.

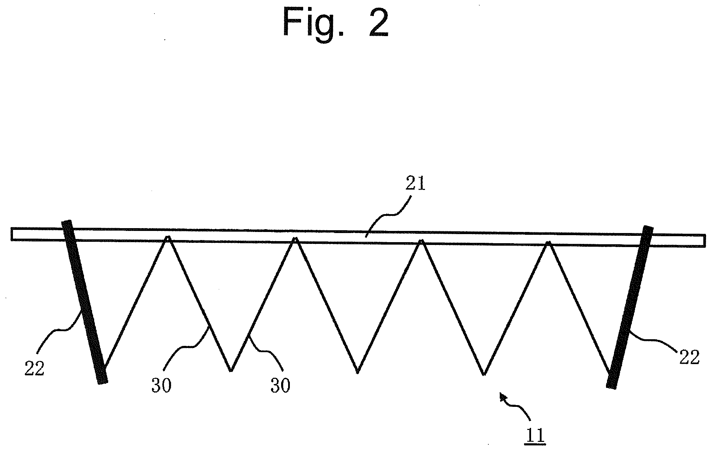

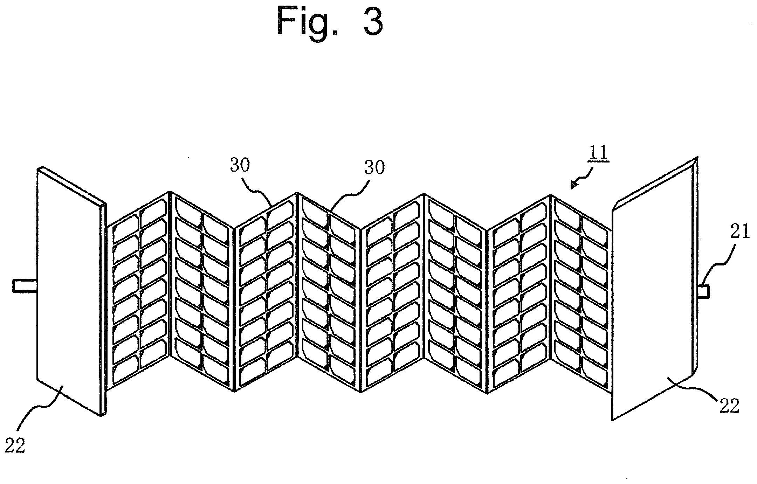

As illustrated in FIGS. 2 and 3, the solar array wing 11 includes a plurality of solar power generators 30 that overlie one another when stowed. Eight of the solar power generators 30 are included in the present embodiment where two or more thereof may be included in the "plurality of solar power generators 30". In the present embodiment, the eight of the solar power generators 30 are connected in a straight line along the direction of expansion of the solar array wing 11. Out of these eight solar power generators 30, the solar power generators 30 on both ends are respectively connected to two presser plates 22 that are attached to an expansion mechanism 21. In the present embodiment, the expansion mechanism 21 is an extension mast.

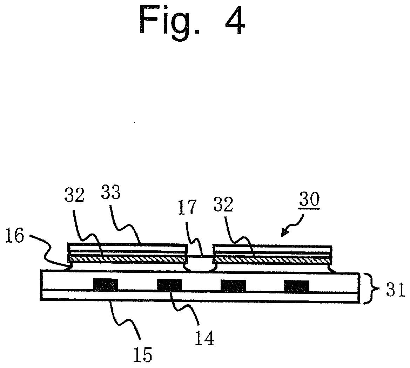

As illustrated in FIG. 4, the solar power generator 30 is a solar array blanket in the present embodiment. Specifically, the solar power generator 30 is formed such that a plurality of solar cells 32 is mounted on the front surface of a support 31 having a structure in which a wiring 14 is sandwiched by a polyimide insulating film 15.

The wiring 14 is a copper foil pattern in the present embodiment but may be in the form of wires or may be a pattern formed of a conductor other than copper.

The solar cell 32 is abbreviated to SC. The solar cell 32 can be referred to simply as "cell". The solar cells 32 are electrically connected to form solar cell circuitry. The solar cells 32 are affixed, at their lower surfaces, to the front surface of the support 31 by an adhesive 16.

An upper surface of each of the solar cells 32 is covered with a protective cover 33. The cover 33 is a cover glass in the present embodiment but may be another type of cover such as a cover made of transparent resin. The solar cell 32 that is integrated with the cover glass is called "cover glass integrated cell". The abbreviation for the cover glass integrated cell is CIC.

The adjacent solar cells 32 are electrically connected by an interconnector 17 that is a metal part for power extraction. The solar cell 32 that is integrated with the interconnector 17 is called "connector integrated cell". The abbreviation for the connector integrated cell is also CIC.

Electric power generated by the solar cell circuitry is extracted from metal parts that are called "bus bars" (not illustrated) and is transmitted to the structure body 12 via the wiring 14.

At the time of a rocket launch, the solar array wings 11 are stowed in folded condition into a fairing 20 of a rocket. After the space structure 10 is exposed to outer space, the solar array wings 11 are each expanded through operation of the expansion mechanism 21 to receive sunlight, and begin power generation. In the present embodiment, in the folded condition of the solar array wing 11, a distance between the solar power generators 30 is small and preferably minimum. Thus, the number of mountable blankets can be increased, or the size and weight of the space structure 10 can be reduced.

A solar array wing using solar array panels, each of which is called a rigid type, has severe upper limits of panel size and the number of panels because of a fairing size limit of the rocket as described above. Even when a substrate of the solar array panel is made thinner for an increased number of panels, there is a structural limit. In the present embodiment, the solar array blankets that are each called a flexible type are adopted, so that an upper limit of the number of blankets is less severe compared with the case where the rigid type is used. This is because the solar cells 32 are mounted on a thin-film structure formed of the insulating film 15 instead of being mounted on a substrate of thick-plate structure. When thin-film solar cells are mounted as the solar cells 32, and the wirings 14 are embedded in the blanket surface for adoption of design that suppresses the height in the outward direction of the interconnector 17 between the solar cells 32, the number of blankets can be increased even further.

The expansion mechanism 21 extends by releasing elastic strain energy that has been stored when a highly elastic member is stowed while being twisted. In the present embodiment, the solar array blankets that are mechanically connected to each other can be expanded through such extension of the expansion mechanism 21. This is unlike release of retaining points that are adopted for the solar array panels, so that retaining point fittings are unnecessary. Accordingly, distance between the stowed blankets can be shorter than that when the rigid type is used. Setting the distance between the blankets such that the solar cells 32 of facing blankets nearly make contact with each other can maximize the number of blankets in the fairing 20.

In the present embodiment, the following structures are adopted for the solar power generators 30 in order to prevent damage to the solar cells 32 and a resulting decline in power generation efficiency even when the space structure 10 is exposed to a rocket launching environment with the solar cells 32 nearly making contact with each other.

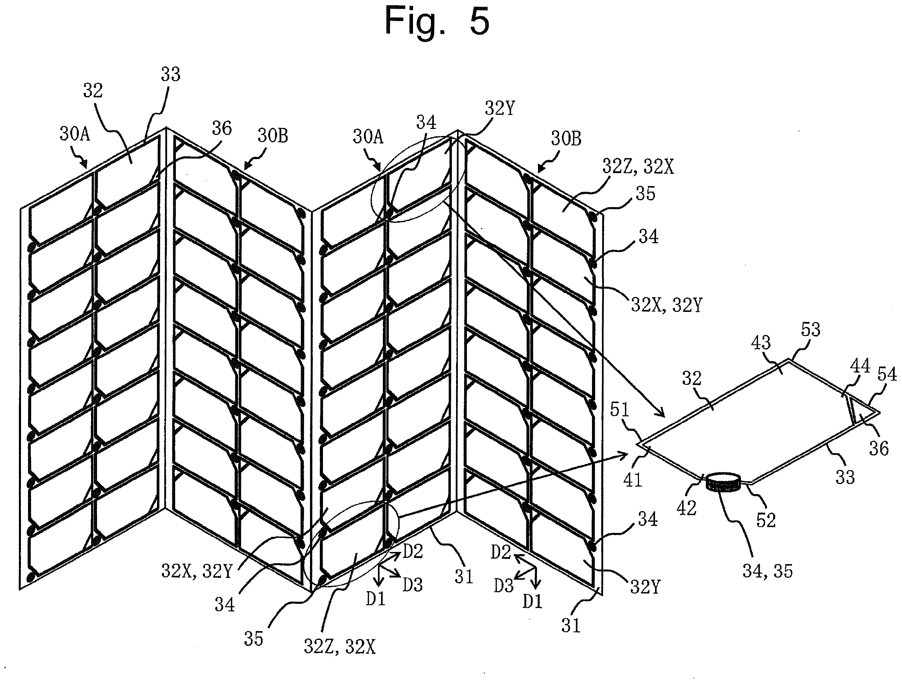

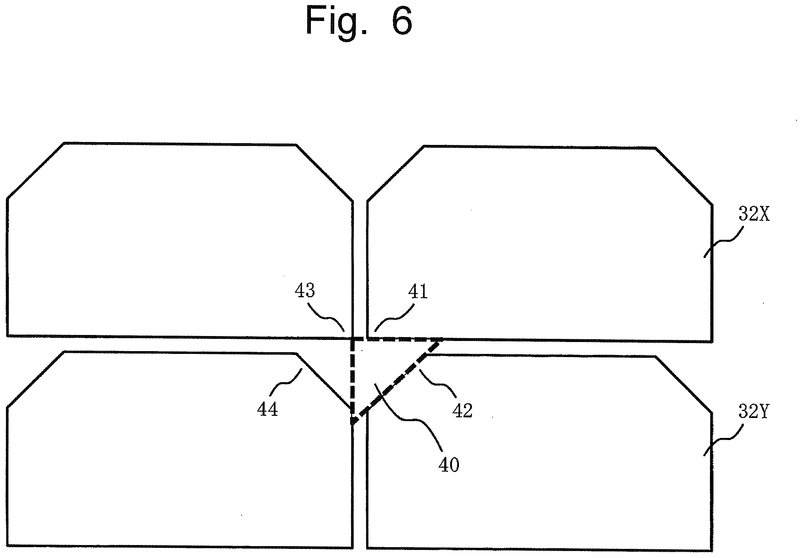

With reference to FIGS. 5 and 6, the structure of each of the solar power generators 30 according to the present embodiment will be described.

FIG. 5 illustrates two pairs of solar power generators 30A and 30B that correspond to any four solar power generators 30 out of the above-mentioned eight solar power generators 30.

The solar power generator 30A overlies the solar power generator 30B when stowed.

The solar power generator 30A includes the support 31, the plurality of solar cells 32, and the plurality of covers 33. The solar power generator 30A also includes cushioning parts 34 and 35 and diodes 36.

As illustrated in FIG. 4, the support 31 of the present embodiment is a blanket provided with the wiring 14 that is electrically connected to the plurality of solar cells 32.

The plurality of solar cells 32 is disposed on the front surface of the support 31. The plurality of solar cells 32 adjoins along length direction D1 of the support 31. The plurality of solar cells 32 may be arranged in a line along the length direction D1 of the support 31. In the present embodiment, the plurality of solar cells 32 is arranged in a plurality of lines, specifically in two lines.

In other words, the plurality of solar cells 32 adjoins along the length direction D1 and width direction D2 of the support 31 in the present embodiment. The number of the solar cells 32 in each of the lines may be two or more but is eight in the present embodiment. The eight solar cells 32 in each of the lines are connected in series to form one solar cell module.

The plurality of solar cells 32 includes first solar cells 32X. Each of the first solar cells 32X has a corner 41 at one end of one side. The plurality of solar cells 32 also includes second solar cells 32Y that are disposed adjacent to the first solar cells 32X. Each of the second solar cells 32Y has a chamfered part 42 at an end, corresponding to the one end, of a side facing the one side.

In the solar power generator 30A illustrated in FIG. 5, the "one side" of the first solar cell 32X is an upper side. The "end" of the first solar cell 32X is a left end. The "side facing the one side" of the second solar cell 32Y is a lower side. The "end corresponding to the one end" of the second solar cell 32Y is a left end. When the i-th solar cell 32 from a bottom of each of the lines is regarded as the first solar cell 32X (where i = 1, ..., 7), the (i + 1)-th solar cell 32 from the bottom of each of the lines corresponds to the second solar cell 32Y in the solar power generator 30A illustrated in FIG. 5.

When viewed along thickness direction D3 of the support 31, the cushioning part 34 is disposed between the corner 41 of the first solar cell 32X and the chamfered part 42 of the second solar cell 32Y. The cushioning part 34 projects more outwardly along the thickness direction D3 of the support 31 than the plurality of solar cells 32. In other words, the cushioning part 34 projects to a higher position than any of the solar cells 32.

The plurality of solar cells 32 also includes third solar cells 32Z that are disposed at or near one edge of the support 31 in the length direction D1. Each of the third solar cells 32Z has a chamfered part 42 at one end on a side near the one edge. In the solar power generator 30A illustrated in FIG. 5, the "one edge" of the support 31 in the length direction D1 is a "lower edge". The "side near the one edge" of the third solar cell 32Z is a lower side.

The "end" of the third solar cell 32Z is a left end. In the solar power generator 30A illustrated in FIG. 5, the first solar cell 32 from the bottom of each of the lines corresponds to the third solar cell 32Z.

When viewed along the thickness direction D3 of the support 31, the cushioning part 35 is disposed between the one edge of the support 31 in the length direction D1 and the chamfered part 42 of the third solar cell 32Z. The cushioning part 35 projects more outwardly along the thickness direction D3 of the support 31 than the plurality of solar cells 32. In other words, the cushioning part 35 projects to a higher position than any of the solar cells 32.

The plurality of covers 33 have transparency. The plurality of covers 33 is mounted on an opposite side from the side, near the support, of the plurality of solar cells 32, that is to say, on the front side of the plurality of solar cells 32.

The cover 33 attached to the first solar cell 32X has a corner 51 in a position corresponding to the corner 41 of the first solar cell 32X. In other words, the cover 33 attached to the first solar cell 32X is formed with the corner 51 that substantially overlies the corner 41 of the first solar cell 32X in the thickness direction D3 of the support 31.

The cover 33 attached to the second solar cell 32Y has a chamfered part 52 in a position corresponding to the chamfered part 42 of the second solar cell 32Y. In other words, the cover 33 attached to the second solar cell 32Y is formed with the chamfered part 52 that substantially overlies the chamfered part 42 of the second solar cell 32Y in the thickness direction D3 of the support 31.

In the present embodiment, the cushioning part 34 projects from between the corner 51 of the cover 33 which is attached to the first solar cell 32X, and the chamfered part 52 of the cover 33 which is attached to the second solar cell 32Y. The cushioning part 34 projects to the higher position than any of the covers 33.

The cover 33 attached to the third solar cell 32Z also has a chamfered part 52 in a position corresponding to the chamfered part 42 of the third solar cell 32Z. In other words, the cover 33 attached to the third solar cell 32Z is formed with the chamfered part 52 that substantially overlies the chamfered part 42 of the third solar cell 32Z in the thickness direction D3 of the support 31.

In the present embodiment, the cushioning part 35 projects from between the one edge of the support 31 in the length direction D1 and the chamfered part 52 of the cover 33 that is attached to the third solar cell 32Z. The cushioning part 35 projects to the higher position than any of the covers 33.

The first solar cell 32X has another corner 43 at another end of a side facing the second solar cell 32Y. The second solar cell 32Y has another chamfered part 44 at an end, corresponding to another end, of a side facing to the first solar cell 32X. In the solar power generator 30A illustrated in FIG. 5, the "side facing the second solar cell 32Y" of the first solar cell 32X is the upper side. The "another end" of the first solar cell 32X is a right end. The "side facing the first solar cell 32X" of the second solar cell 32Y is the lower side. The "end corresponding to another end" of the second solar cell 32Y is a right end.

The third solar cell 32Z has another chamfered part 44 at another end of a side near the one edge of the support 31 in the length direction D1. In the solar power generator 30A illustrated in FIG. 5, the "another end" of the third solar cell 32Z is a right end.

The cover 33 attached to the first solar cell 32X has a corner 53 in a position corresponding to the corner 43 of the first solar cell 32X. In other words, the cover 33 attached to the first solar cell 32X is formed with the corner 53 that substantially overlies the corner 43 of the first solar cell 32X in the thickness direction D3 of the support 31.

The cover 33 attached to the second solar cell 32Y has a corner 54, not a chamfered part, in a position corresponding to the chamfered part 44 of the second solar cell 32Y. In other words, the cover 33 attached to the second solar cell 32Y is formed with the corner 54 that partially overlies the chamfered part 44 of the second solar cell 32Y in the thickness direction D3 of the support 31.

The cover 33 attached to the third solar cell 32Z also has a corner 54, not a chamfered part, in a position corresponding to the chamfered part 44 of the third solar cell 32Z. In other words, the cover 33 attached to the third solar cell 32Z is formed with the corner 54 that partially overlies the chamfered part 44 of the third solar cell 32Z in the thickness direction D3 of the support 31.

Each of the diodes 36 is an element that is joined to corresponding one of the plurality of solar cells 32 to bypass the solar cell 32. The diode 36 that bypasses the second solar cell 32Y is disposed between the corner 43 of the first solar cell 32X and the chamfered part 44 of the second solar cell 32Y. The diode 36 bypassing the second solar cell 32Y is covered by the corner 54 of the cover 33 that is attached to the second solar cell 32Y.

The diode 36 that bypasses the third solar cell 32Z is disposed between the one edge of the support 31 in the length direction D1 and the chamfered part 44 of the third solar cell 32Z. The diode 36 that bypasses the third solar cell 32Z is also covered by the corner 54 of the cover 33 that is attached to the third solar cell 32Z.

The cushioning parts 34 and 35 may be made of any material that delivers a cushioning function but is an adhesive that is applied to the front surface of the support 31 in the present embodiment. Specifically, the adhesive used for the cushioning parts 34 and 35 is, for improved efficiency of a manufacturing process and for a reduced material cost, the same as the adhesive 16 used to bond the solar cells 32 to the front surface of the support 31. The cushioning parts 34 and 35 may have any shape but are cylindrical or dome-shaped in the present embodiment because the cushioning parts 34 and 35 are the adhesives that have been dropped and hardened on the front surface of the support 31.

In the present embodiment, the plurality of solar cells 32 each have the shape of a rectangular plate that has two corners cut off to be polygonal. As such, a triangular area 40 is formed, as illustrated in FIG. 6, between the corner 41 of the first solar cell 32X and the chamfered part 42 of the second solar cell 32Y. The cushioning part 34 has such a diameter as to fit in this area 40. An inscribed circle of the area 40 is assumed to have a diameter of about 50 millimeters. Thus, the diameter of the cushioning part 34 is preferably not more than 50 millimeters.

The cushioning part 35 has the same diameter as the cushioning part 34. Note that the plurality of solar cells 32 each may have the shape of a rectangular plate that has one corner cut off to be polygonal with the diode 36 omitted. Note here that a method of manufacturing the solar cell 32 having the shape of the rectangular plate that has its one or two corners cut off to be polygonal is not limited to inclusion of a process of actually cutting off the corner(s) but may be the one that provides, as a final shape, the polygonal plate without the corner(s).

The cushioning parts 34 and 35 have such a height as to exceed the sum of a thickness of the solar cell 32 and a thickness of the cover 33. In cases where the thin-film solar cells are adopted, the sum of the thickness dimensions of the solar cell 32 and the cover 33 is assumed to be less than 100 micrometers. Thus, the height of the cushioning parts 34 and 35 is preferably 100 micrometers or more. It is also preferable that the height of the cushioning parts 34 and 35 be equal to or less than 1 centimeter in order for the distance between the blankets to decrease.

In the present embodiment, the height of the cushioning parts 34 and 35 is such as to enable maintenance of a minimum contact-free clearance between the solar cells 32 of the adjoining blankets when the solar array wing 11 is in folded condition. Consequently, damage on the solar cells 32 caused by a collision between the solar cells 32 in the rocket launching environment can be prevented.

The solar power generator 30B is structurally similar to the solar power generator 30A, except that the solar cell modules are oppositely oriented in consideration of a magnetic moment. In other words, the solar power generator 30B has a structure of the solar power generator 30A that has been rotated by 180 degrees viewed from the front.

In the present embodiment, when the plurality of solar power generators 30 is stowed, the cushioning parts 34 and 35 of the solar power generator 30A, which is one of two solar power generators 30 overlying each other out of the plurality of solar power generators 30 face the corner 41 of the solar power generator 30B, which is the other one of the two solar power generators 30.

### Description of the Effect of the Embodiment

In the present embodiment, when viewed along the thickness direction D3 of the support 31, the cushioning part 34 projecting outward along the thickness direction D3 of the support 31 is disposed between the corner 41 of the first solar cell 32X and the chamfered part 42 of the second solar cell 32Y that is adjacent to the first solar cell 32X.

When viewed along the thickness direction D3 of the support 31, the cushioning part 35 projecting outward along the thickness direction D3 of the support 31 is disposed between the one edge of the support 31 in the length direction D1 and the chamfered part 42 of the third solar cell 32Z. As such, damage caused by contact between the solar cells 32 that are disposed on the front surfaces of the supports 31 can be prevented without impeding increase of output power.

In the present embodiment, the cushioning part 34 or 35 is installed in the vacant area 40 at the cell end where the diode 36 is not installed. The cushioning parts 34 and 35 are installed directly on the support 31 and are of such size as to fit in the vacant area 40 at the cell end, so that there is no decrease in power generation area of the solar cell 32.

In the present embodiment, installation of the cushioning parts 34 and 35 in the vacant areas 40 at the cell ends can be carried out together with a process of bonding the solar cells 32. Thus, the formation of the cushioning parts 34 and 35 is low-cost and easy. Since the cushioning parts 34 and 35 are formed only on the cell-mounting surfaces, universal design of the blankets is enabled. In addition, costs can be suppressed and time and effort in design, manufacture, and test can be reduced.

The present embodiment can contribute to reductions in size and weight of the satellite and an increase in electric power while avoiding cost increase and reliability degradation.

### Another Configuration

In the present embodiment, one cushioning parts 34 or 35 is installed for every one of the solar cells 32. However, one cushioning parts 34 or 35 may be installed for many of the solar cells 32, depending on blanket size and cell size. With the number of cushioning parts 34 or 35 reduced, weight reduction and manufacturing simplification are possible within a range of durability in the launching environment.

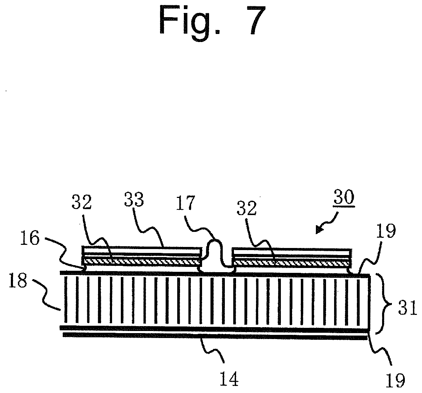

In the present embodiment, the solar power generator 30 is formed as the solar array blanket as illustrated in FIG. 4. However, in a variation, the solar power generator 30 may be formed as a solar array panel as illustrated in FIG. 7.

In this variation, the solar power generator 30 is formed such that solar cells 32 and wiring 14 are mounted on the front surface and the back surface of the support 31, respectively. The support has a structure in which a honeycomb core 18 made of aluminum is sandwiched between face sheets 19 made of carbon fiber reinforced plastic. The support 31 corresponds to the substrate mentioned earlier. The abbreviation for the carbon fiber reinforced plastic is CFRP. Note that the material of the honeycomb core 18 is not limited to aluminum but may be another material such as carbon.

### Second Embodiment

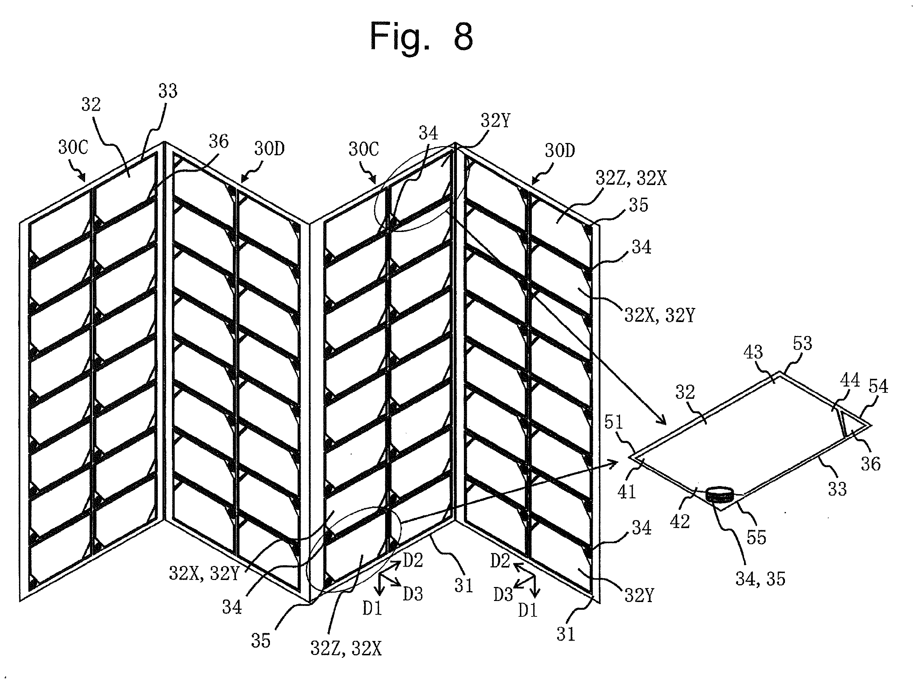

With reference to FIG. 8, differences between this embodiment and the first embodiment will be mainly described.

### Description of Configuration

With reference to FIG. 8, a structure of each of solar power generators 30 according to the present embodiment will be described.

Similarly to FIG. 5, FIG. 8 illustrates two pairs of solar power generators 30C and 30D that correspond to any four solar power generators 30 out of the eight solar power generators 30.

The solar power generator 30C overlies the solar power generator 30D when stowed.

The solar power generator 30C is structurally similar to the solar power generator 30A of the first embodiment except for the following points.

A cover 33 attached to a second solar cell 32Y has a corner 55, not a chamfered part, in a position corresponding to a chamfered part 42 of the second solar cell 32Y. In other words, the cover 33 attached to the second solar cell 32Y is formed with the corner 55 that partially overlies the chamfered part 42 of the second solar cell 32Y in the thickness direction D3 of a support 31.

In the present embodiment, a cushioning part 34 is disposed on a front surface of the cover 33 that is attached to the second solar cell 32Y. The cushioning part 34 is disposed between a corner 41 of the first solar cell 32X and the chamfered part 42 of the second solar cell 32Y when viewed along the thickness direction D3 direction of the support 31 as same as the first embodiment. The point that the cushioning part 34 projects more outwardly along the thickness direction D3 of the support 31 than the plurality of solar cells 32 is also the same as the first embodiment.

A cover 33 attached to a third solar cell 32Z also has a corner 55, not a chamfered part, in a position corresponding to the chamfered part 42 of the third solar cell 32Z. In other words, the cover 33 attached to the third solar cell 32Z is formed with the corner 55 that partially overlies the chamfered part 42 of the third solar cell 32Z in the thickness direction D3 of the support 31.

In the present embodiment, the cushioning part 35 is disposed on a front surface of the cover 33 that is attached to the third solar cell 32Z. The cushioning part 35 is disposed between the one edge of the support 31 in the length direction D1 and the chamfered part 42 of the third solar cell 32Z when viewed along the thickness direction D3 of the support 31 as same as the first embodiment. The cushioning part 35 projects more outwardly along the thickness direction D3 of the support 31 than the plurality of solar cells 32 as same as the first embodiment.

The cushioning parts 34 and 35 may be made of any material that delivers a cushioning function but are adhesives that are applied to the front surface of the cover 33 in the present embodiment. Specifically, the adhesive used for the cushioning parts 34 and 35 is, for improved efficiency of a manufacturing process and for a reduced material cost, the same as the adhesive 16 used to bond the solar cells 32 to the front surface of the support 31. The cushioning parts 34 and 35 may have any shape but are cylindrical or dome-shaped in the present embodiment because of being the adhesives that are dropped and harden on the front surface of the cover 33.

As with the first embodiment, the diameter of the cushioning parts 34 and 35 is preferably not more than 50 millimeters.

The height of the cushioning parts 34 and 35 may be less than 100 micrometers unlike the first embodiment. Preferably, the height of the cushioning parts 34 and 35 is not more than 1 centimeter in order for the distance between the blankets to decrease.

In the present embodiment, the height of the cushioning parts 34 and 35 is such as to enable maintenance of the minimum contact-free clearance between the solar cells 32 of the adjoining blankets when a solar array wing 11 is in folded condition as with the first embodiment. Consequently, damage on the solar cells 32 caused by a collision between the solar cells 32 in the rocket launching environment can be prevented.

The solar power generator 30D is structurally similar to the solar power generator 30C, except that the solar cell modules are oppositely oriented in consideration of the magnetic moment. In other words, the solar power generator 30D has a structure of the solar power generator 30C that has been rotated by 180 degrees viewed from the front.

### Description of the Effect of the Embodiment

In the present embodiment, in addition to effects equivalents to the effects of the first embodiment, increased rigidity of the solar power generator 30 can be obtained effectively because when impact is applied to the cushioning parts 34 and 35, the cover 33 can receive the impact.

In the present embodiment, the cover 33 is of such size as to cover the vacant area 40 that is positioned at the cell end where the diode 36 is not installed. Since the cushioning parts 34 and 35 are installed on and supported by the rigid cover 33, the impact absorbing effect of the cushioning parts 34 and 35 is enhanced. Since the cushioning parts 34 and 35 are of such size as to fit in the vacant area 40 at the cell end as with the first embodiment, there is no decrease in power generation area of the solar cell 32.

### Another Configuration

In the present embodiment, one cushioning part 34 or 35 is installed for every one of the solar cells 32 as with the first embodiment. However, the number of those cushioning parts 34 or 35 may be reduced.

In the present embodiment, the solar power generator 30 is formed as the solar array blanket as with the first embodiment. However, the solar power generator 30 may be formed as a solar array panel as with the variation of the first embodiment.

### Third Embodiment

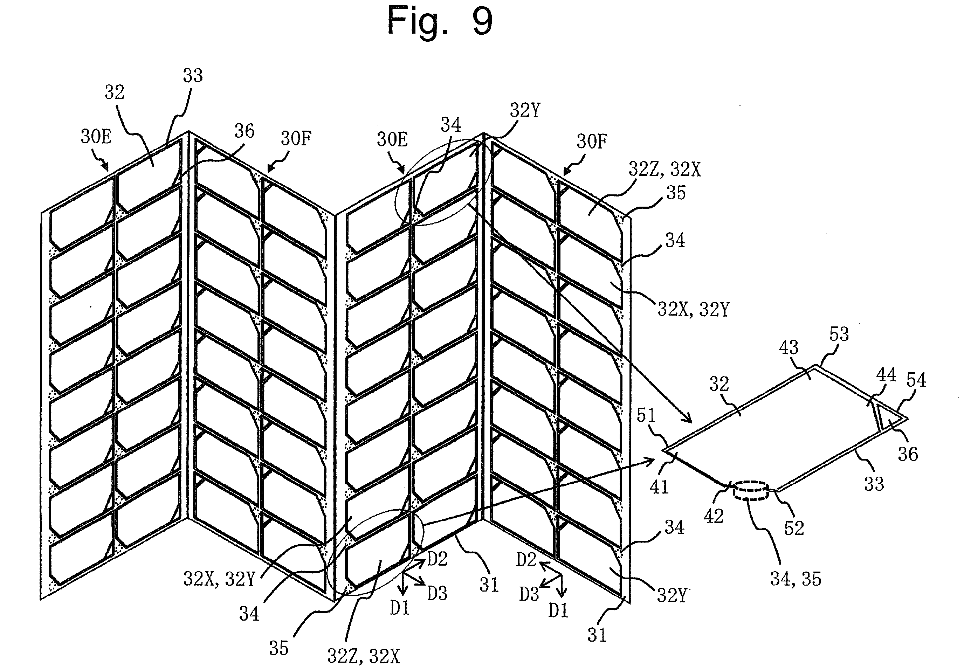

With reference to FIG. 9, a difference between this embodiment and the first embodiment will be mainly described.

### Description of Configuration

With reference to FIG. 9, a structure of each of solar power generators 30 according to the present embodiment will be described.

Similarly to FIG. 5, FIG. 9 illustrates two pairs of solar power generators 30E and 30F that correspond to any four solar power generators 30 out of the eight solar power generators 30.

The solar power generator 30E overlies the solar power generator 30F when stowed.

The solar power generator 30E is structurally similar to the solar power generator 30A of the first embodiment except for the following point.

In the present embodiment, cushioning parts 34 and 35 are raised parts on the front surface of a support 31, not an adhesive applied to the front surface of the support 31. The cushioning parts 34 and 35 of the support 31 are formed by a method such as embossing in which a film structure of the blanket is pressed between dies having convex portions and concavity portions. The cushioning parts 34 and 35 may have any shape but are cylindrical in the present embodiment.

The solar power generator 30F is structurally similar to the solar power generator 30E, except that the solar cell modules are oppositely oriented in consideration of the magnetic moment. In other words, the solar power generator 30F has a structure of the solar power generator 30E that has been rotated by 180 degrees viewed from the front.

### Description of the Effect of the Embodiment

In the present embodiment, in addition to effects equivalents to the effects of the first embodiment, the following effects can be obtained. The cushioning parts 34 and 35 can be provided on the blanket before the cells are mounted, whereby the solar cells 32 can be positioned.

In the present embodiment, the cushioning parts 34 and 35 can be provided only by performing a process of forming raised portions on the blanket in advance. Thus, the formation of the cushioning parts 34 and 35 is low-cost and easy. Since the cushioning parts 34 and 35 are formed only on the cell-mounting surface, universal design of the blankets is enabled. In addition, costs can be suppressed and time and effort in designing, manufacture, and testing can be reduced.

### Another Configuration

In the present embodiment, one cushioning part 34 or 35 is installed for every one of the solar cells 32 as with the first embodiment. However, the number of those cushioning parts 34 or 35 may be reduced.

In the present embodiment, the solar power generator 30 is formed as the solar array blanket as with the first embodiment. However, the solar power generator 30 may be formed as a solar array panel as with the variation of the first embodiment.

### Fourth Embodiment

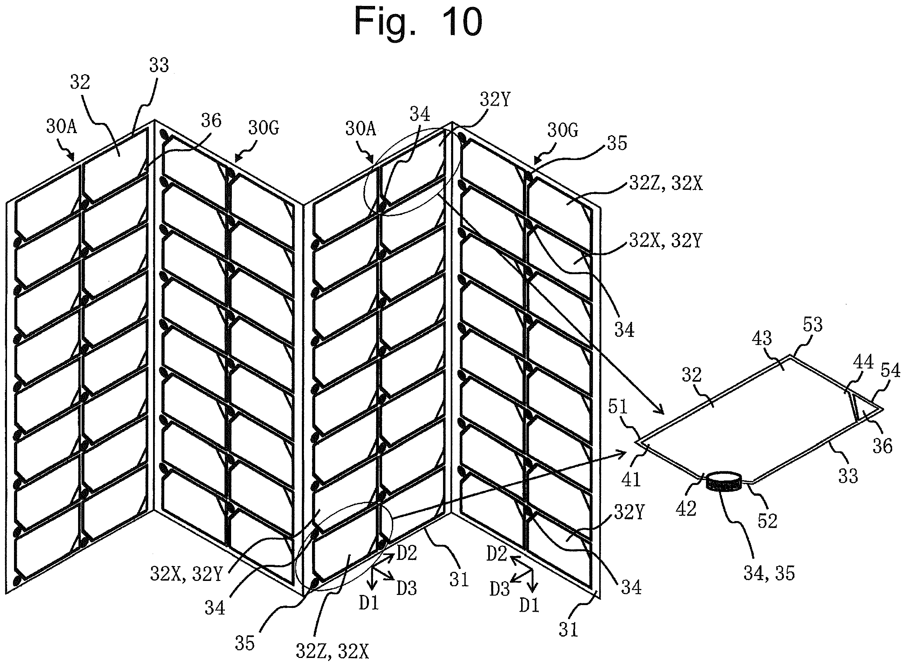

With reference to FIG. 10, differences between this embodiment and the first embodiment is described.

### Description of Configuration

With reference to FIG. 10, a structure of each of solar power generators 30 according to the present embodiment is described.

Similarly to FIG. 5, FIG. 10 illustrates two pairs of solar power generators 30A and 30G that correspond to any four solar power generators 30 out of the eight solar power generators 30.

The solar power generator 30A overlies on the solar power generator 30G when solar power generators 30 is stowed.

The solar power generator 30A is structurally the same as the solar power generator 30A of the first embodiment.

The solar power generator 30G is structurally the same as the solar power generator 30B of the first embodiment, except that cushioning parts 34 and 35 have changed places with the diode 36. In other words, the solar power generator 30G has a structure of the solar power generator 30A that has been turned over in a length direction D1 of a support 31.

The first solar cell 32X has a corner 41 at one end of one side. The second solar cell 32Y is disposed adjacent to the first solar cell 32X and has a chamfered part 42 at an end, corresponding to the one end, of a side facing the one side. The second solar cell 32Y has a corner 43 at another end of a side that is opposite from the side facing the one side. In the solar power generator 30G illustrated in FIG. 10, the "one side" of the first solar cell 32X is a lower side as with the solar power generator 30B illustrated in FIG. 5.

The "end" of the first solar cell 32X is a left end unlike the solar power generator 30B illustrated in FIG. 5. The "side facing to the one side" of the second solar cell 32Y is upper side as with the solar power generator 30B illustrated in FIG. 5. The "end corresponding to the one end" of the second solar cell 32Y is a left end unlike the solar power generator 30B illustrated in FIG. 5. The "side that is opposite from the side facing the one side" of the second solar cell 32Y is a lower side as with the solar power generator 30B illustrated in FIG. 5,.

The "another end" of the second solar cell 32Y is a right end unlike the solar power generator 30B illustrated in FIG. 5. When the i-th solar cell 32 from a top of each of the lines is regarded as the first solar cell 32X (where i = 1, ..., 7) in the solar power generator 30G illustrated in FIG. 10, the (i + 1)-th solar cell 32 from the top of each of the lines corresponds to the second solar cell 32Y as with the solar power generator 30B illustrated in FIG. 5.

The cushioning part 34 is disposed between the corner 41 of the first solar cell 32X and the chamfered part 42 of the second solar cell 32Y when viewed along the thickness direction D3 of the support 31 as same as the solar power generator 30B of the first embodiment. The cushioning part 34 projects more outwardly along the thickness direction D3 of the support 31 than the plurality of solar cells 32 as same as the solar power generator 30B of the first embodiment.

A third solar cell 32Z is disposed at or near another edge of the support 31 in the length direction D1 and has a chamfered part 42 at one end of a side near another edge in the length direction. The third solar cell 32Z has a corner 43 at another end of a side that is opposite from the side near another edge in the length direction. In the solar power generator 30G illustrated in FIG. 10, "another edge" of the support 31 in the length direction D1 is an upper edge as with the solar power generator 30B illustrated in FIG. 5. The "side near another edge in the length direction" of the third solar cell 32Z is an upper side as with the solar power generator 30B illustrated in FIG. 5.

The "end" of the third solar cell 32Z is a left end unlike the solar power generator 30B illustrated in FIG. 5. The "side that is opposite from the side near another edge in the length direction" of the third solar cell 32Z is a lower side as with the solar power generator 30B illustrated in FIG. 5. The "another end" of the third solar cell 32Z is a right end unlike the solar power generator 30B illustrated in FIG. 5. In the solar power generator 30G illustrated in FIG. 10, the first solar cell 32 from the top of each of the lines corresponds to the third solar cell 32Z as with the solar power generator 30B illustrated in FIG. 5.

The cushioning part 35 is disposed between another edge of the support 31 in the length direction D1 and the chamfered part 42 of the third solar cell 32Z when viewed along the thickness direction D3 of the support 31, as same as the solar power generator 30B of the first embodiment,. The cushioning part 35 projects more outwardly along the thickness direction D3 of the support 31 than the plurality of solar cells 32 as same as the solar power generator 30B of the first embodiment.

The first solar cell 32X has another corner 43 at another end of a side facing the second solar cell 32Y. The second solar cell 32Y has another chamfered part 44 at the end, corresponding to another end, of the side facing the first solar cell 32X. In the solar power generator 30G illustrated in FIG. 10, the "side facing the second solar cell 32Y" of the first solar cell 32X is the lower side as with the solar power generator 30B illustrated in FIG. 5.

The "another end" of the first solar cell 32X is a right end as with the solar power generator 30B illustrated in FIG. 5. The "side facing the first solar cell 32X" of the second solar cell 32Y is the upper side as with the solar power generator 30B illustrated in FIG. 5. The "end corresponding to another end" of the second solar cell 32Y is the right end unlike the solar power generator 30B illustrated in FIG. 5.

The third solar cell 32Z has another chamfered part 44 at another end of the side near another edge of the support 31 in the length direction D1. In the solar power generator 30G illustrated in FIG. 10, "another end" of the third solar cell 32Z is the right end unlike the solar power generator 30B illustrated in FIG. 5.

The diode 36 that bypasses the second solar cell 32Y is disposed between the corner 43 of the first solar cell 32X and the chamfered part 44 of the second solar cell 32Y as same as the solar power generator 30B of the first embodiment. The diode 36 that bypasses the third solar cell 32Z is disposed between another edge of the support 31 in the length direction D1 and the chamfered part 44 of the third solar cell 32Z as same as the solar power generator 30B of the first embodiment also.

From the above descriptions, differences regarding the covers 33 from the solar power generator 30B are obvious and thus are not described.

In the present embodiment, when the plurality of solar power generators 30 is stowed, the cushioning parts 34 and 35 of the solar power generator 30A, which is one of the two solar power generators 30 overlying each other out of the plurality of solar power generators 30, face the corner 43 of the solar power generator 30G, which is the other one of the two solar power generators 30. This means that in the present embodiment, the positions of the cushioning parts 34 and 35, and the joined position of the diode 36 with respect to the solar cell 32 are reversed between the adjoining solar power generators 30A and 30G.

As such, the cushioning parts 34 and 35 of the blankets that are adjoining and in contact with each other are in diagonal positions of the solar cell 32 when these blankets are stowed. When a solar array wing 11 is folded, the solar power generator 30 thus has improved flatness compared to the first embodiment, and the distance between the blankets can be decreased even further.

### Description of the Effect of the Embodiment

In the present embodiment, in addition to effects equivalents to the effects of the first embodiment, the following effect can be obtained. Since the solar power generator 30 has the improved flatness when the solar array wing 11 is folded, the solar array wing 11 can be made smaller when stowed.

### Another Configuration

In the present embodiment, the cushioning parts 34 and 35 are adhesives that are applied to the front surface of the support 31 as with the first embodiment. However, the cushioning parts 34 and 35 may be the adhesives applied to the front surface of the cover 33 as with the second embodiment. Alternatively, the cushioning parts 34 and 35 may be raised parts on the front surface of the support 31 as with the third embodiment.

In the present embodiment, one cushioning parts 34 or 35 is deposited on every solar cells 32 as with the first embodiment. However, the number of those cushioning parts 34 or 35 may be reduced.

In the present embodiment, the solar power generator 30 is solar array blanket as with the first embodiment. However, the solar power generator 30 may be composed of a solar array panel as with the variation of the first embodiment.

### Fifth Embodiment

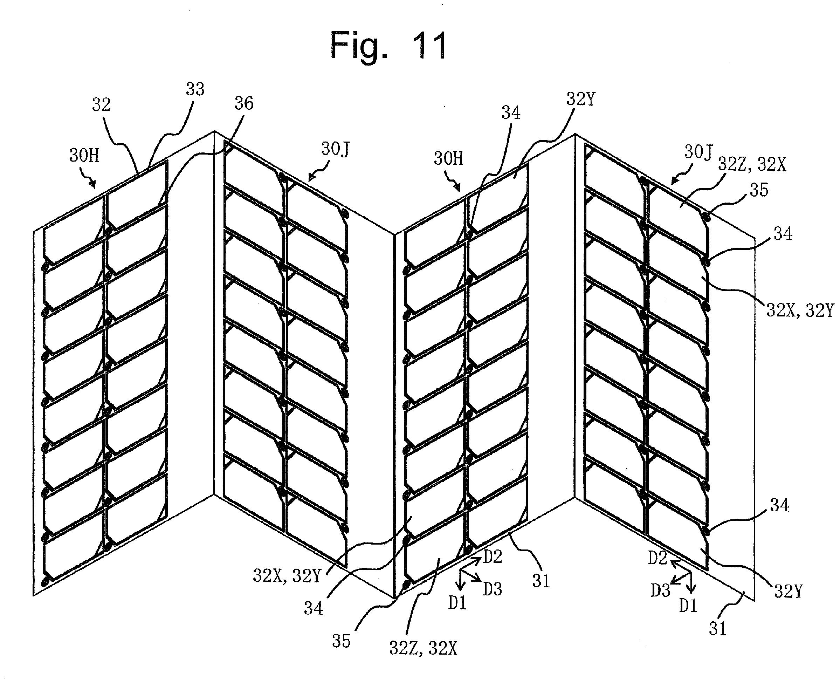

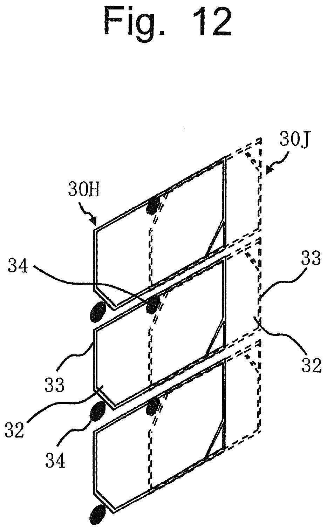

With reference to FIGS. 11 and 12, a difference between this embodiment and the first embodiment will be mainly described.

### Description of Configuration

With reference to FIGS. 11 and 12, a structure of each of solar power generators 30 according to the present embodiment will be described.

Similarly to FIG. 5, FIG. 11 illustrates two pairs of solar power generators 30H and 30J that correspond to any four solar power generators 30 out of the eight solar power generators 30.

The solar power generator 30H overlies the solar power generator 30J when stowed.

The solar power generators 30H and 30J are structurally similar to the respective solar power generators 30A and 30B of the first embodiment except for the following point.

On each of the plurality of solar power generators 30 of the present embodiment, a plurality of solar cells 32 as a whole is shifted to one edge of a support 31 in the width direction D2. For this reason, a distance between the one edge of the support 31 in the width direction D2 and a solar cell 32 that is the closest to the above one edge in the width direction is smaller than a distance between another edge of the support 31 in the width direction D2 and a solar cell 32 that is the closest to the above another edge in the width direction.

A difference between these two distances is preferably smaller than a width of one of the solar cells 32 and is about half the width of one of the solar cells 32 in the present embodiment. In the solar power generators 30H and 30J illustrated in FIG. 11, the "one edge" of the support 31 in the width direction D2 is a left edge, while the "another edge" in the width direction D2 is a right edge.

In the present embodiment, as illustrated in FIG. 12, when the plurality of solar power generators 30 is stowed, the plurality of solar cells 32 of the solar power generator 30H, which is one of the two solar power generators 30 overlying each other out of the plurality of solar power generators 30 faces the plurality of solar cells 32 of the solar power generator 30J, which is the other one of the two solar power generators 30, in positions that are shifted in the width direction D2 of the support 31.

In other words, on the adjoining solar power generators 30H and 30J, the positions of the solar cells 32 are intentionally shifted from the same side of ends of the blankets in the present embodiment. As such, the positions of cushioning parts 34 and 35 of the blankets that are adjoining and in contact with each other when these blankets are stowed are shifted from each other in the width direction D2 of the support 31. When a solar array wing 11 is folded, the solar power generator 30 thus has improved flatness compared to the first embodiment, and the distance between the blankets can be decreased even further.

### Description of the Effect of the Embodiment

In the present embodiment, in addition to effects equivalents to the effects of the first embodiment, the following effect can be obtained. Because the solar power generator 30 has the improved flatness when the solar array wing 11 is folded, the solar array wing 11 can be made smaller when stowed.

### Another Configuration

In the present embodiment, the cushioning parts 34 and 35 are adhesives that are applied to the front surface of the support 31 as with the first embodiment. However, the cushioning parts 34 and 35 may be the adhesives applied to the front surface of the cover 33 as with the second embodiment. Alternatively, the cushioning parts 34 and 35 may be raised parts on the front surface of the support 31 as with the third embodiment. The positions of the cushioning parts 34 and 35 and the joined position of the diode 36 with respect to the solar cell 32 may be reversed between the adjoining solar power generators 30H and 30J as with the fourth embodiment.

In the present embodiment, one cushioning part 34 or 35 is deposited on every solar cells 32 as with the first embodiment. However, the number of those cushioning parts 34 or 35 may be reduced.

In the present embodiment, the solar power generator 30 is solar array blanket as with the first embodiment. However, the solar power generator 30 may be formed as a solar array panel as with the variation of the first embodiment.

### Sixth Embodiment

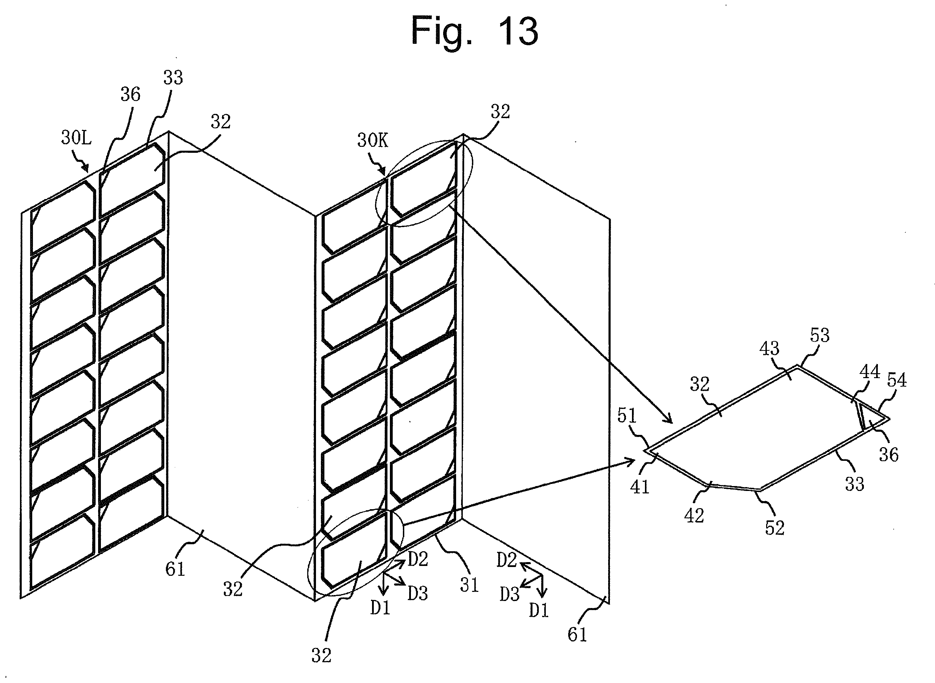

With reference to FIG. 13, differences between this embodiment and the first embodiment will be mainly described.

### Description of the Configuration

With reference to FIG. 13, a structure of each of solar power generators 30 according to the present embodiment will be described.

In the present embodiment, the plurality of solar power generators 30 is not connected contiguously, but the plurality of solar power generators 30 and a plurality of supports 61 that are not equiped with solar cells 32 are alternately connected. The number of the solar power generators 30 included in the "plurality of solar power generators 30" may be two or more but is four in the present embodiment.

This means that out of those eight solar power generators 30 of the first embodiment, odd-numbered or even-numbered solar power generators 30 from one end are replaced with the supports 61 with no solar cells 32 in the present embodiment. Moreover, the solar power generators 30 are structurally different from those of the first embodiment.

FIG. 13 illustrates solar power generators 30K and 30L, which correspond to any two solar power generators 30 out of the four solar power generators 30, and two supports 61 that are connected to the solar power generators 30K and 30L, respectively.

When stowed, the solar power generators 30K and 30L overlie on the supports 61, respectively.

The solar power generators 30K and 30L are structurally similar to the respective solar power generators 30A and 30B of the first embodiment, except that cushioning parts 34 and 35 are not deposited.

The support 61 is structurally similar to the support 31 of the solar power generator 30, except that no solar cells 32 are mounted.

As described above, a solar array wing 11 of the present embodiment has a structure in which the blankets equipped with the solar cells 32 and the blankets mounted with no solar cells 32 are alternately connected, thus allowing the blanket itself to deliver a cushioning function..

In the present embodiment, only one of the adjoining blankets is equipped with the solar cells 32, and the blankets equipped with the solar cells 32 and the blankets with no solar cells 32 are alternately connected. As such, when stowed, the blanket with no solar cells 32 plays a role as a cushioning member, thus protecting the front surfaces of the mounted solar cells 32 of the counter blanket. Consequently, damage on the solar cells 32 caused by a collision between the solar cells 32 in the rocket launching environment can be prevented.

### Description of the Effect of the Embodiment

The present embodiment eliminates the need for deposition of the cushioning parts 34 and 35 and improves the flatness of the blanket even further compared to the first through fifth embodiments.

### Another Configuration

The present embodiment differs from the first through fifth embodiments in that no cushioning parts 34 and 35 are installed. However, as with the first through fifth embodiments, one cushioning part 34 or 35 may be installed for one or many of the solar cells 32.

### Seventh Embodiment

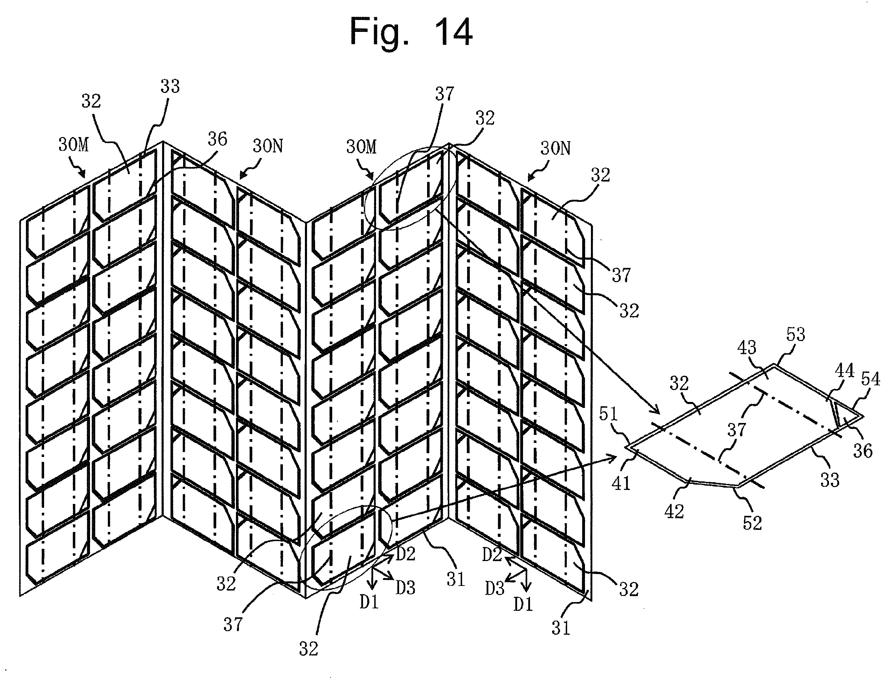

With reference to FIG. 14, a difference between this embodiment and the first embodiment will be mainly described.

### Description of Configuration

With reference to FIG. 14, a structure of each of solar power generators 30 according to the present embodiment will be described.

Similarly to FIG. 5, FIG. 14 illustrates two pairs of solar power generators 30M and 30N that correspond to any four solar power generators 30 out of the eight solar power generators 30.

The solar power generator 30M overlies the solar power generator 30N when stowed.

The solar power generators 30M and 30N are structurally similar to the respective solar power generators 30A and 30B of the first embodiment except for the following point.

The solar power generators 30M and 30N each include spacers 37 instead of the cushioning parts 34 and 35.

The spacers 37 are each installed extensively from the one edge to another edge of the support 31 in the length direction D1 while being in contact with or having space from the front surfaces of covers 33 that are attached to solar cells 32. In the present embodiment, the spacers 37 extend linearly along the lines of the solar cells 32. The number of the spacers 37 may be at least one for each of the lines of the solar cells 32 but is two for each of the lines of the solar cells 32 in the present embodiment. Each of the spacers 37 may be a metal wire but is preferably formed of a material that is unlikely to break the cover glass, such as a binding thread made of fiber. Moreover, in order to achieve a minimum decrease in power generation area of the solar cell 32, the spacer 37 is preferably in line form that is as fine as possible.

The spacer 37 is positioned at a height to keep a minimum contact-free clearance between the solar cells 32 of the adjoining blankets when a solar array wing 11 is in folded condition. Consequently, damage on the solar cells 32 caused by a collision between the solar cells 32 in the rocket launching environment can be prevented.

### Description of the Effect of the Embodiment

The present embodiment eliminates the need for formation of the cushioning parts 34 and 35 and enables the spacers 37 to be disposed evenly at a front surface of the blanket, thereby improving the flatness of the blanket even further compared to the first through fifth embodiments.

### Another Configuration

In the present embodiment, the two spacers 37 are provided for all of the solar cells 32. However, one and three or more spacers 37 may be provided for all of the solar cells 32, depending on the blanket size and the cell size. Alternatively, only one of the adjoining blankets may be provided with the spacers 37. With the number of spacers 37 reduced, weight reduction and manufacturing simplification are possible within a range of durability in the launching environment.

The present embodiment differs from the first through fifth embodiments in that no cushioning parts 34 and 35 are installed. However, as with the first through fifth embodiments, one cushioning part 34 or 35 may be installed for one or many of the solar cells 32.

In the present embodiment, the solar power generator 30 is formed as the solar array blanket as with the first embodiment. However, the solar power generator 30 may be formed as a solar array panel as with the variation of the first embodiment.

Although the embodiments of the present invention have been described, two or more of those embodiments may be combined and implemented. Alternatively, one or a combination of two or more of those embodiments may be partially implemented. Note that the present invention is not to be limited by those embodiments but can be modified in various manners as needed.

### List of Reference Signs

- 10: space structure
- 11: solar array wing
- 12: structure body
- 13: antenna
- 14: wiring
- 15: insulating film
- 16: adhesive
- 17: interconnector
- 18: honeycomb core
- 19: face sheet
- 20: fairing
- 21: deployment mechanism
- 22: presser plate
- 30: solar power generator
- 30A: solar power generator
- 30B: solar power generator
- 30C: solar power generator
- 30D: solar power generator
- 30E: solar power generator
- 30F: solar power generator
- 30G: solar power generator
- 30H: solar power generator
- 30J: solar power generator
- 30K: solar power generator
- 30L: solar power generator
- 30M: solar power generator
- 30N: solar power generator
- 31: support
- 32: solar cell
- 32X: first solar cell
- 32Y: second solar cell
- 32Z: third solar cell
- 33: cover
- 34: cushioning part
- 35: cushioning part
- 36: diode
- 37: spacer
- 40: area
- 41: corner
- 42: chamfered part
- 43: corner
- 44: chamfered part
- 51: corner
- 52: chamfered part
- 53: corner
- 54: corner
- 55: corner
- 61: support

## Claims

1. A solar power generator that overlies another solar power generator when stowed, the solar power generator comprising:
a support;
a plurality of solar cells disposed on a front surface of the support and adjoined along a length direction of the support, the plurality of solar cells including:
a first solar cell including a corner at one end of one side; and
a second solar cell that is disposed adjacent to the first solar cell and includes a chamfered part at an end, corresponding to the one end, of a side facing the one side; and
a cushioning part that is disposed between the corner of the first solar cell and the chamfered part of the second solar cell when viewed along a thickness direction of the support and projects more outwardly along the thickness direction of the support than the plurality of solar cells.

2. The solar power generator according to claim 1,
further comprising
a plurality of covers, having transparency, mounted on a side opposite from a side of the plurality of solar cells close to the support, wherein
a cover of the plurality of covers attached to the first solar cell includes a corner in a position corresponding to the corner of the first solar cell,
a cover of the plurality of covers attached to the second solar cell includes a chamfered part in a position corresponding to the chamfered part of the second solar cell, and
the cushioning part projects from between the corner of the cover attached to the first solar cell and the chamfered part of the cover attached to the second solar cell.

3. The solar power generator according to claim 2,
wherein the cushioning part is an adhesive applied to the front surface of the support.

4. The solar power generator according to claim 2,
wherein the cushioning part is a raised part on the front surface of the support.

5. The solar power generator according to claim 1,
further comprising
a plurality of covers, having transparency, mounted on a side of the plurality of solar cells that is opposite from a side of the plurality of solar cells close to the support, wherein
a cover of the plurality of covers attached to the first solar cell includes a corner in a position corresponding to the corner of the first solar cell,
a cover of the plurality of covers attached to the second solar cell includes a corner in a position corresponding to the chamfered part of the second solar cell, and
the cushioning part is disposed on a front surface of the cover attached to the second solar cell.

6. The solar power generator according to claim 5,
wherein the cushioning part is an adhesive applied to the front surface of the cover attached to the second solar cell.

7. The solar power generator according to any one of claims 1 to 6, further comprising a diode that bypasses the second solar cell,
wherein
the first solar cell further includes another corner at another end of a side facing the second solar cell,
the second solar cell further includes another chamfered part at an end, corresponding to the other end, of a side facing the first solar cell; and the diode is disposed between another corner and another chamfered part.

8. The solar power generator according to any one of claims 1 to 6,
wherein each of the plurality of solar cells has a polygonal shape formed by cutting off one or two corners of a rectangular plate.

9. The solar power generator according to any one of claims 1 to 8,
wherein the support is a blanket provided with wiring that is electrically connected to the plurality of solar cells.

10. A solar array wing comprising a plurality of solar power generators that overlies one another when stowed,
wherein each of the plurality of solar power generators is a solar power generator according to any one of claims 1 to 9.

11. The solar array wing according to claim 10,
wherein
the second solar cell further includes a corner at another end of a side that is opposite from the side facing the one side, and
when the plurality of solar power generators is stowed, the cushioning part of one of two solar power generators being overlying each other out of the plurality of solar power generators faces the corner of the second solar cell of another of the two solar power generators.

12. The solar array wing according to claim 10,
wherein when the plurality of solar power generators is stowed, the plurality of solar cells of one of two solar power generators being overlying each other out of the plurality of solar power generators faces the plurality of solar cells of another of the two solar power generators in a position that is shifted in a width direction of the support.

13. A space structure
comprising the solar array wing according to any one of claims 10 to 12.
